# EUROPEAN PATENT APPLICATION

(11) **EP 4 030 299 A2**
(43) Date of publication of application: **20.07.2022**
(21) Application number: 21217310.8
(22) Date of filing: 23.12.2021
(51) Int. Cl.: G06F 11/36

(54) **METHOD, DEVICE, AND SYSTEM FOR SIMULATION TEST**

(30) Priority: 18.01.2021 CN 202110062943
(71) Applicant: Beijing Tusen Zhitu Technology Co., Ltd., Beijing 100016 (CN)
(72) Inventor: WANG, Yuyong, Beijing, 100016 (CN); SUI, Qingyu, Beijing, 100016 (CN); JI, Pingyuan, Beijing, 100016 (CN); HAO, Jianan, Beijing, 100016 (CN); NIE, Lei, Beijing, 100016 (CN); WANG, Haocheng, Beijing, 100016 (CN)
(74) Representative: Murgitroyd & Company

(57) **Abstract**

The present disclosure relates to intelligent driving technology, and provides a method, device, and system for simulation test. The method includes: retrieving data in a first format for a first sensor from a database; processing the data in the first format to obtain corresponding data in a second format, the second format being a format of data collected by the first sensor in a real-world operating environment; and transmitting the data in the second format to a second computing device, such that the second computing device performs a simulation test based on the data in the second format. The present disclosure can provide a simulation test solution for an intelligent system, capable of providing a simulation test environment closer to the real-world environment.

## Description

### TECHNICAL FIELD

The present disclosure relates to intelligent driving technology, and more particularly, to a method, device, and system for simulation test.

### BACKGROUND

Currently, the intelligent driving technology, which relies on sensors for perception and uses artificial intelligence to provide motion decision and control for vehicles, robots, Unmanned Aerial Vehicles (UAVs), etc., has achieved unprecedented development.

Central processing units of autonomous vehicles, intelligent robots, UAVs, etc., such as vehicle servers on autonomous vehicles or main control computers of intelligent robots or UAVs, are typically provided with intelligent systems. Various types of algorithm functional modules (or referred to as computing modules), such as perception processing modules, localization processing modules, decision-making modules, control modules, and the like. In order to ensure proper functioning of the intelligent systems, intelligent system manufacturers may update the various types of functional modules in the intelligent systems iteratively and frequently to meet requirements of intelligent driving. Thus, it is critical to test the intelligent systems.

Generally, the testing of the intelligent system can be performed in the real world. That is, autonomous vehicles, intelligent robots, UAVs, etc., can be brought to a real-world scene for testing. However, this requires a considerable amount of physical resources such as vehicles, robots, and UAVs, and is not applicable to large-scale testing. Therefore, how to perform simulation test of an intelligent system has become a problem to be solved.

### SUMMARY

The embodiments of the present disclosure provide a method, device, and system for simulation test, capable of performing a simulation test on an intelligent system.

In order to achieve the above object, the following solutions are provided according to the embodiments of the present disclosure.

In a first aspect, a method for simulation test is provided according to an embodiment of the present disclosure. The method is performed in a first computing device and includes: retrieving data in a first format for a first sensor from a database; processing the data in the first format to obtain corresponding data in a second format, the second format being a format of data collection of the first sensor (i.e., the second format being a format of data collected by the first sensor in a real-world operating environment); and transmitting the data in the second format to a second computing device, such that the second computing device performs a simulation test based on the data in the second format.

In a second aspect, a device for simulation test is provided according to an embodiment of the present disclosure. The device includes: a database retrieving unit configured to retrieve data in a first format for a first sensor from a database; a data processing unit configured to process the data in the first format to obtain corresponding data in a second format, the second format being a format of data collection of the first sensor (i.e., the second format being a format of data collected by the first sensor in a real-world operating environment); and a data transmitting unit configured to transmit the data in the second format to a second computing device, such that the second computing device performs a simulation test based on the data in the second format.

In a third aspect, a system for simulation test is provided according to an embodiment of the present disclosure. The system includes a first computing device and a second computing device that are communicatively connected with each other. The first computing device is configured to retrieve data in a first format for a first sensor from a database, process the data in the first format to obtain corresponding data in a second format, and transmit the data in the second format to the second computing device. The second computing device is configured to perform a simulation test based on the received data in the second format.

In a fourth aspect, a computer readable storage medium is provided according to an embodiment of the present disclosure. The computer readable storage medium contains a program or instructions which, when executed on a computer, cause the computer to perform the method for simulation test according to the above first aspect.

In a fifth aspect, a computing device is provided according to an embodiment of the present disclosure. The computing device includes a memory and one or more processors communicatively connected to the memory. The memory stores instructions executable by the one or more processors. The instructions, when executed by the one or more processors, cause the one or more processors to perform the method for simulation test according to the above first aspect.

According to the technical solutions of the present disclosure, the device for simulation test can be provided independently of the second computing device (such as a vehicle server), and can independently perform tasks of retrieving, reproducing and transmitting data packets, such that the second computing device, where an intelligent system is located, can perform a simulation test in accordance with a real-world operating environment, thereby correctly simulating and reproducing the real operation condition and resource occupation condition of vehicle software, and obtaining same verification results as the real vehicle environment.

Moreover, the data format obtained by the device for simulation test from the database is the format of data that is processed in the real-world operating environment and then stored by the second computing device. The data in the second format as obtained after processing is the data that is collected by the real sensor in the real-world operating environment. The data in the second format is nothing different from data packets collected by the real sensor, such that the process of transmitting the data collected by the real sensor can be faithfully reproduced.

Further, the present disclosure can simulate the data transmission line between the real sensor and the second computing device, and comprehensively consider the load condition of the transmission path, so as to fully simulate the process during intelligent driving in which data packets are collected by a sensor, then transmitted to a vehicle server via a real transmission path, and processed by the vehicle server. Moreover, the present disclosure can also simulate an exposure delay and a processing delay before the sensor data is transmitted. The data in the second format will be transmitted to the vehicle server after a predetermined delay, such that the simulation test environment can be closer to the real-world situation.

### BRIEF DESCRIPTION OF THE DRAWINGS

In order to describe the technical solutions according to the embodiments of the present disclosure or the prior art more clearly, figures used in description of the embodiments or the prior art will be introduced briefly below. Obviously, the figures described below only illustrate some embodiments of the present disclosure, and other figures can be obtained by those of ordinary skill in the art based on these drawings without any inventive efforts.
Fig. 1 is a first flowchart illustrating a method 100 for simulation test according to an embodiment of the present disclosure;
Fig. 2 is a second flowchart illustrating a method 200 for simulation test according to an embodiment of the present disclosure;
Fig. 3 is a schematic diagram showing a structure of a conventional simulation test scene;
Fig. 4 is a schematic diagram showing a structure of a simulation test scene according to an embodiment of the present disclosure;
Fig. 5 is a schematic diagram showing a comparison between software data flows in a real vehicle test and in a simulation test;
Fig. 6 is a third flowchart illustrating a method 600 for simulation test according to an embodiment of the present disclosure;
Fig. 7 is a schematic diagram showing forward processing and reverse processing on sensor data according to an embodiment of the present disclosure;
Fig. 8 is a schematic diagram showing a structure of a device 800 for simulation test according to an embodiment of the present disclosure;
Fig. 9 is a schematic diagram showing a structure of a system 900 for simulation test according to an embodiment of the present disclosure; and
Fig. 10 is a schematic diagram showing a structure of a computing device 1000 according to an embodiment of the present disclosure.

### DETAILED DESCRIPTION OF THE EMBODIMENTS

In the following, the solutions according to the embodiments of the present disclosure will be described clearly and completely with reference to the figures. Obviously, the embodiments described below are only some, rather than all, of the embodiments of the present disclosure. All other embodiments that can be obtained by those skilled in the art based on the embodiments described in the present disclosure without any inventive efforts are to be encompassed by the scope of the present disclosure.

It is to be noted that the terms "first" and "second" in the description and claims of the present disclosure and the above-mentioned figures are used to distinguish similar objects from each other, and are not necessarily used to describe a specific sequence or order. It should be understood that the data used in this way can be interchanged as appropriate for the purpose of illustration of the embodiments of the present disclosure. In addition, the terms "comprising" and "having" and any variants thereof are intended to cover non-exclusive inclusions. For example, a process, method, system, product or device that includes a series of steps or units is not necessarily limited to those steps or units that are explicitly listed, and may include other steps or units that are not explicitly listed or are inherent to the process, method, product, or device.

In order to allow those skilled in the art to better understand the present disclosure, some of the technical terms used in the embodiments of the present disclosure are explained as follows:

Point cloud: A set of point data on an outer surface of an object as obtained by a measuring apparatus is referred to as a point cloud.

IMU: Inertial Measurement Unit (IMU) is a device that measures a three-axis attitude angle (or angular rate) and acceleration of an object.

Frame: Measurement data received by a sensor in an observation. For example, one frame of data is an image for a camera, or a set of laser point clouds for a laser radar.

A "vehicle" as used in the present disclosure may typically include: a power system, a sensor system, a control system, peripheral devices and a computer system. In other embodiments, a vehicle may include more, fewer, or different systems.

Here, the power system is a system that supplies power to the vehicle, including: an engine/motor, a transmission, wheels/tyres, and a power source unit.

The control system may include a combination of devices that control the vehicle and its components, such as a steering unit, a throttle, and a brake unit.

The peripheral devices may be devices that allow the vehicle to interact with at least one of external sensors, other vehicles, external computing devices, or users, including but not limited to, a wireless communication system, a touch screen, a microphone, or a speaker.

Based on the vehicle described above, an autonomous vehicle can be further provided with a sensor system and an autonomous driving control device.

The sensor system may include a plurality of sensors for sensing information on an environment in which the vehicle is located, and one or more actuators that change respective positions or directions of the sensors. The sensor system may include any combination of sensors such as a Global Positioning System (GPS) sensor, an Inertial Measurement Unit (IMU), a Radio Detection and Ranging (RADAR) unit, a camera, a laser rangefinder, a Light Detection and Ranging (LIDAR) unit, and an acoustic sensor. The sensor system may further include sensors that monitor the vehicle's internal systems (such as an O₂ monitor, a fuel gauge, an engine thermometer, etc.).

The autonomous driving control device may include a processor and a memory having at least one machine executable instruction stored therein. The processor executes the at least one machine executable instruction to provide functions including e.g., a map engine, a positioning module, a perception module, a navigation or route module, and an autonomous control module. The map engine and the positioning module are configured to provide map information and positioning information. The perception module is configured to perceive objects in the environment around the vehicle based on information obtained by the sensor system and the map information provided by the map engine. The navigation or route module is configured to plan a driving route for the vehicle based on processing results from the map engine, the positioning module and the perception module. The autonomous control module is configured to convert decision information inputted from the modules such as the navigation or route module into a control command for outputting to a vehicle control system, and transmit the control command to respective components in the vehicle control system over an in-vehicle network (for example, an in-vehicle electronic network system implemented using a CAN bus, a local interconnection network, a multimedia directional system transmission, etc.) for autonomous control of the vehicle. The autonomous control module can also obtain information on respective components in the vehicle via the in-vehicle network. Generally, different types of sensors can be mounted on the vehicle, and each sensor has its corresponding format of collected data (referred to as second format, or original data format). Typically, the second format cannot be used by an intelligent system (including a number of algorithm functional modules) of a vehicle server directly. Therefore, the vehicle server needs to first process the data in the second format into the first format, and then input the data in the first format to the intelligent system for algorithm-based computation. Moreover, the vehicle server can also upload the processed data in the first format to a database for storage. That is, the first format is the processed format or stored format of the original data.

Currently, there are mainly the following two schemes for simulation test of intelligent systems.

One scheme is to generate sensor information from a virtual scene using an environment model and a sensor model, and input it to an intelligent system for simulation test. However, this scheme has high requirements for construction of the virtual scene, which involves various issues such as 3D rendering and 3D modeling. In this case, the virtual scene needs to be supported by a large amount of computing power and requires a high cost to construct, which severely wastes computing resources. The virtual scene significantly deviates from a real-world scene in which the intelligent system operates. As a result, it is difficult to simulate the operating condition of the intelligent system in the real-world scene.

Another scheme is to play back pre-collected sensor data and input it to an intelligent system for simulation test. However, the played back data here is directly obtained from a database. Such data is in a first format and can be directly inputted to the intelligent system for use. In this case, a vehicle server does not process a second format into the first format before inputting it to the intelligent system as a real vehicle does, thus a part of real network load and computing resource usage of the sensor software is ignored, and a data transmission and processing process in the real vehicle environment cannot be simulated. As a result, the simulation test of the intelligent system is incomplete and cannot faithfully reflect the actual operating scene of the intelligent system, which affects the accuracy of the simulation test.

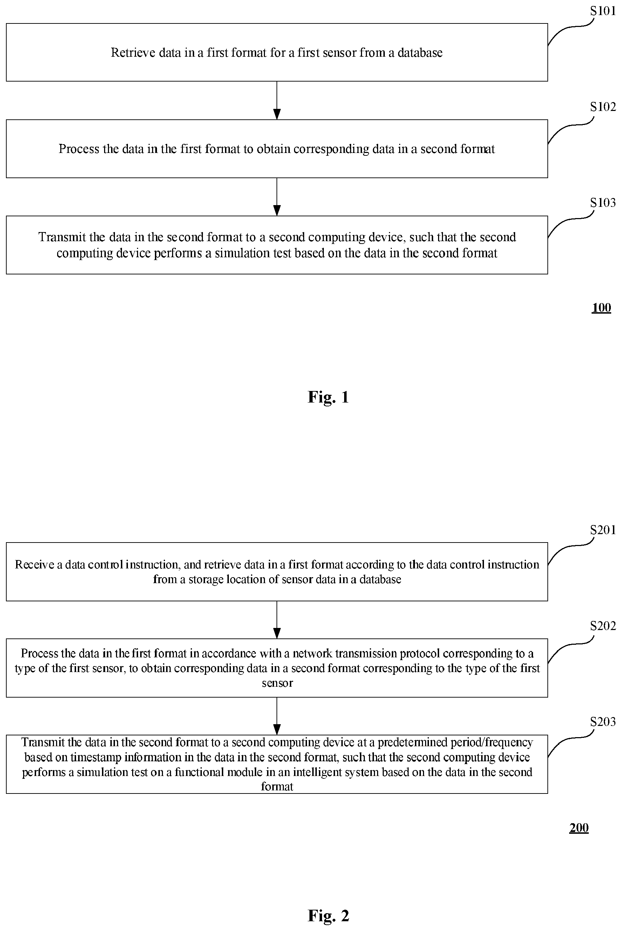

In order to overcome the problems of the related art, as shown in Fig. 1, an embodiment of the present disclosure provides a method 100 for simulation test. The method 100 can be performed in a first computing device, which can be a virtual sensor computing platform or a virtual sensor system which can integrate functions of a number of real sensors without data collecting modules of the real sensors. Data can be retrieved directly from a database, processed, and transmitted to a second computing device such as a vehicle server. As shown in Fig. 1, the method 100 includes the following steps.

At step S101, data in a first format for at least one first sensor is retrieved from a database.

At step S102, the data in the first format for the first sensor is processed to obtain corresponding data in a second format. The second format is a format of data collection of the first sensor (i.e., the second format being a format of data collected by the first sensor.

At step S103, the data in the second format for the first sensor is transmitted to a second computing device, such that the second computing device performs a simulation test based on the received data in the second format. Here, the second computing device performs the simulation test on a its intelligent system, and the intelligent system includes at least one algorithm module, such as a perception algorithm module, a localization algorithm module, a decision algorithm module, and a control algorithm module.

In order to enable those skilled in the art to better understand the present disclosure, a more detailed embodiment will be given below. As shown in Fig. 2, an embodiment of the present disclosure provides a method 200 for simulation test. The method 200 includes the following steps.

At step S201, a data control instruction is received, and data in a first format corresponding to the data control instruction is retrieved from a storage location of sensor data in a database.

Here, the data control instruction may contain a condition for data to be selected. The condition for the data to be selected may include at least one of a target data name, a target data identity, and a target time period. Among them, the target data name and the target data identity can be a target drive test data name and a target drive test data identity, respectively.

Then, the step S201 of receiving the data control instruction and retrieving the data in the first format corresponding to the data control instruction from the storage location of the sensor data in the database can be implemented by: receiving the data control instruction, and retrieving the data in the first format corresponding to the condition for the data to be selected from the storage location of the sensor data in the database.

In addition, the data control instruction may further include a start control instruction and a pause control instruction.

Then, the step S201 of receiving the data control instruction and retrieving the data in the first format corresponding to the data control instruction from the storage location of the sensor data in the database can be implemented by:
in response to receiving the pause control instruction while retrieving the data in the first format, pausing the retrieving of the data in the first format, and entering a data-not-retrieved state; and
in response to receiving the start control instruction while in the data-not-retrieved state, resuming the retrieving of the data in the first format from the storage location of the sensor data in the database, and entering a data-retrieved state.

Here, various types of sensor data can be collected in different scenes, such as traffic jam scenes, high-speed scenes, etc., such that the sensor data in these scenes can be played back and tested by simulation, thereby analyzing request conditions and resource occupation conditions in these different scenes.

It can be appreciated that the data control instruction may include other control instructions, such as acceleration control instruction, deceleration control instruction, etc. The present disclosure is not limited to these examples. In response to receiving the acceleration control instruction, the retrieval of the sensor data can be accelerated, or in response to receiving the deceleration control instruction, the retrieval of the sensor data can be decelerated. The specific acceleration and deceleration values can be set by those skilled in the art as desired and the present disclosure is not limited thereto.

At step S202, the data in the first format is processed in accordance with a network transmission protocol corresponding to a type of the first sensor (this is referred to as forward processing, including a serialization process of the data), to obtain corresponding data in a second format.

According to an embodiment of the present disclosure, the first sensor may include at least one of an image capturing device, a point cloud capturing device such as lidar, and a Global Navigation Satellite System (GNSS) sensor.

For the image capturing device, the corresponding data in the first format may include compressed image data, and the network transmission protocol may include a Gigabit Ethernet based image transmission standard protocol (e.g., GigE Vision). In this case, the step S202 of processing the data in the first format for the first sensor to obtain the corresponding data in the second format can be implemented by: decompressing the compressed image data to form image data in a Blue, Green, and Red (BGR) format, and performing an image format conversion on the image data in the BGR format to form Bayer image data corresponding to the image capturing device, as one or more original image data packets conforming to the GigE Vision protocol.

For the point cloud capturing device such as a lidar or radar, the corresponding data in the first format may include a point cloud data packet group, and the network transmission protocol may include a User Datagram Protocol (UDP) and a Transmission Control Protocol (TCP). In this case, the step S202 of processing the data in the first format for the first sensor to obtain the corresponding data in the second format can be implemented by: decomposing the point cloud data packet group to form one or more point cloud data packets corresponding to the point cloud capturing device such as the lidar, as one or more original point cloud data packets conforming to the UDP and the TCP.

Here, when point cloud capturing device such as the lidar is collecting laser point clouds, typically for a collection range of one circle (360°), the point clouds collected every 0.2° form a data packet (i.e., point cloud data packet), and every 10 data packets constitute a data packet group (i.e., point cloud data packet group). In this way, the lidar generates 180 data packet group every circle. However, these data packet groups cannot be directly transmitted over the network using UDP and TCP protocols. Thus, they need to be decomposed into data packets as the original data packets conforming to the UDP and TCP protocols. Here, each data packet contains point cloud information and the GPS information of the lidar. The point cloud information will be transmitted using the UDP, and the GPS information of the lidar will be transmitted using the TCP.

For the GNSS sensor, the data in the first format may include stored GNSS data, and the network transmission protocol may include the TCP. In this case, the step S202 of processing the data in the first format for the first sensor to obtain the corresponding data in the second format can be implemented by: decoding the stored GNSS data (e.g., denoted as GnssMsg) to form GNSS information data (e.g., denoted as GnssInfo); and encoding the GNSS information data to form one or more GNSS network data packets (e.g., denoted as GnssPacket) corresponding to the GNSS sensor, as one or more original GNSS data packets conforming to the TCP.

At step S203, the data in the second format is transmitted to a second computing device at a predetermined period/frequency based on timestamp information of the data in the second format, such that the second computing device can perform a simulation test on a functional module in an intelligent system based on the data in the second format.

In particular, each original data packet has timestamp information. For example, three consecutive original data packets have their timestamp information differing from each other by 0.1s sequentially, and a predetermined period is 0.1s. Then, according to system time, the original data packets corresponding to the respective timestamp information can be transmitted every 0.1s.

Since real sensor data has certain exposure time and processing time, and the data exposure time may be different in different light conditions, the present disclosure can further record the data delay of the real data so as to faithfully reproduce the data delay during the data playback process. Preferably, the timestamp information may include at least one of triggering timestamp, exposure time, and processing time for the data in the second format. Here, the actual time length of exposure and processing can be directly recorded as the exposure time and the processing time; or an exposure timestamp and a processing completion timestamp (or data transmitting timestamp) can be recorded, and the exposure time and the processing time can be calculated based on these timestamps in combination with the triggering timestamp. The present disclosure is not limited to any specific scheme for recording the two time lengths. The step S203 can be implemented by: transmitting the data in the second format to the second computing device at a predetermined period/frequency based on a corrected timestamp for the data in the second format, the corrected timestamp being a triggering timestamp for the data in the second format plus a time delay.

Here, any of the following is used as the time delay (when one of the following options is selected, all the obtained original data packets will be processed accordingly):
1) a sum of predetermined exposure time and predetermined processing time;
2) a sum of the exposure time for the data in the second format and the predetermined processing time; or
3) a sum of the exposure time and the processing time for the data in the second format.

Here, the predetermined exposure time and the predetermined processing time may be average exposure time and average processing time obtained based on a priori knowledge, respectively, and the present disclosure is not limited to any specific values thereof. The original data packets being transmitted at the predetermined cycle frequency specifically means that a data transmission is triggered every transmission period to transmit the data that needs to be transmitted currently. Assuming that the triggering timestamps of three original data packets are 100ms, 200ms, and 300ms, and the first delay is 15ms, the corresponding corrected timestamps are 115ms, 215ms, and 315ms, and the triggering period is 0.1s. Then, a data transmission is triggered every 0.1s to sequentially transmit the data in a queue that needs to be transmitted currently.

In the second option, since the delay of the processing time is relatively fixed, when the data is played back, only the delay of the exposure time of the data packets is reproduced, while the delay of the processing time may simply be the predetermined processing time, thereby increasing the data computation speed and accordingly the data transmission speed under the premise of restoring the real data transmission as much as possible. In the third option, both the exposure time and the processing time of each data packet are played back, such that the data transmission process for a real vehicle can be reproduced more faithfully and the accuracy of the test can be improved.

In addition, the data in the second format for the first sensor can be transmitted to the second computing device by: transmitting the data in the second format for at least one first sensor to the second computing device via a simulated data transmission line between the first sensor and the second computing device.

Generally, there may be a plurality of first sensors in a real-world operating environment, and each first sensor is connected to the second computing device via a network bus. In a first implementation, the simulated data transmission line can be a network bus between any of the plurality of first sensors and the second computing device. In a second implementation, the simulated data transmission line can be a network bus with a median length among a plurality of network buses between the respective ones of the plurality of first sensors and the second computing device. In yet another implementation, a length of the transmission line between each of the plurality of first sensors and the second computing device can be calculated, and an average length of all the transmission lines can be calculated. Then, a transmission line with a predetermined length can be selected as the simulated data transmission line, and the predetermined length is smaller than or equal to the average length.

Specifically, an average parameter, e.g., an average length, of network buses between respective sensors and a server on a real vehicle can be calculated in advance, and the network bus with the average parameter can be selected as the predetermined path. Since the network bus parameters of the respective sensors do not differ too much, and the lengths have a relatively small impact on each data transmission, this approach can simplify the construction of the virtual server, reduce the complexity of data transmission, and reproduce the real-world data transmission condition.

In a third implementation, the first computing device can be provided data interfaces corresponding to respective types of sensors on a real vehicle, and each data interface can use a network bus between the corresponding sensor position on the real vehicle and the vehicle server to transmit the data corresponding to the type of sensor, thereby completely reproducing the real-world data transmission process.

In order to enable those skilled in the art to better understand the present disclosure, some embodiments of the present disclosure will be described below with reference to an actual simulation test scene.

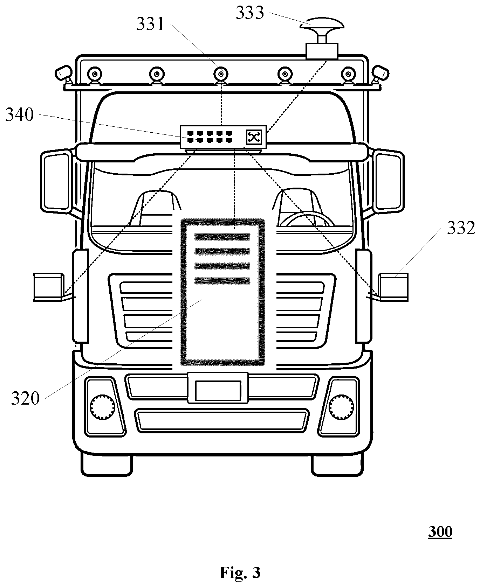

For an autonomous vehicle as an example, the intelligent system is an autonomous driving system. As shown in Fig. 3, the autonomous driving vehicle 300 is typically provided with a second computing device 320, various sensors, and a switch 340. Here, the second computing device 320 is the server (i.e., vehicle server on the autonomous vehicle) where the intelligent system is located. The various sensors may include, for example, an image capturing device 331 (such as a camera), a point cloud capturing device (such as a lidar) 332, and a GNSS sensor 333 (such as an integrated navigation device). Each sensor and the second computing device 320 are communicatively connected to each other through a switch 340 to form a data transmission path of a network bus.

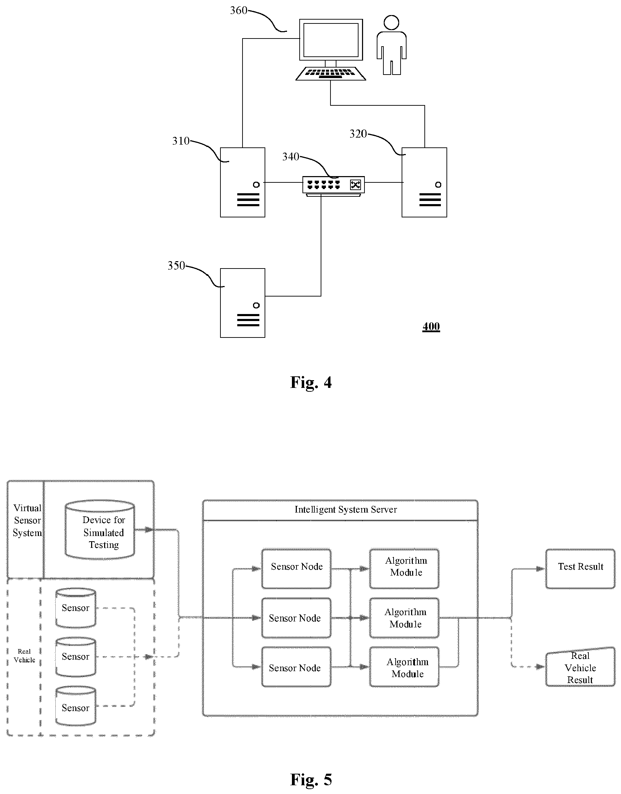

In order to perform a simulation test on the intelligent system, an embodiment of the present disclosure provides a system 400 for simulation test, as shown in Fig. 4. The system 400 for simulation test is provided with a server, referred to as a first computing device 310, for virtualizing the various sensors. The first computing device 310 can replace the various sensors on the real vehicle, and can be connected to the second computing device 320 through the switch 340 to form a data transmission path of the network bus. In this way, the system 400 for simulation test can be placed in an indoor environment such as an office, a factory building, etc., for simulation test, and there is no need for a real vehicle field test in a real vehicle environment. In addition, it is to be noted that the first computing device 310 described in the present disclosure can be provided in a computer room, an office, etc., and the second computing device 320 can be provided in a computer room, an office, an autonomous vehicle, etc. The two devices can be arranged in the same venue or in different venues, and the present disclosure is not limited to these examples.

In addition, the first computing device 310 may also be connected to a database 350 through the switch 340 to retrieve data in a first format from the database 350 for processing, and transmit the processed data in a second format to the second computing device 320. It is to be noted that the autonomous vehicle 300 may include a plurality of (for example, two) second computing devices 320 for processing different sensor data, respectively. Correspondingly, there may be one or more first computing device 310 and one or more second computing device 320 in the system 400 for simulation test, and the present disclosure is not limited to any specific number of the first or second computing devices in the system 400 for simulation test. The first computing device 310 is configured to process data from different types of sensors and transmit the data to the corresponding second computing device 320. Here, an association relationship among the types of sensors, the first computing device(s), and the second computing device(s) 320 may be predetermined, so as to retrieve and distribute data according to the association relationship.

Moreover, in order to facilitate observation of the simulation test of the intelligent system by a tester, the system 400 for simulation test may also be provided with a display front end 360. The first computing device 310 is provided with a state monitoring service (which may be a software sub-module) for exchanging data with the second computing device 320, the computing core of the first computing device 310, and the display front end 360, and monitoring the state of the first computing device 310. The state monitoring service receives a state control command from the second computing device 320, and forwards the state control command to the computing core of the first computing device 310. The computing core transmits its own state to the state monitoring service in real time, and the state monitoring service pushes the state to the display front end 360 for displaying, such that the tester can check the state conveniently.

Here, the state monitoring service may be a Remote Procedure Call (RPC) service, which acquires a control instruction from the second computing device 320 in a Python environment. The computing core of the first computing device 310 runs in a C++ environment. Therefore, the present disclosure provides conversion between Python statements for the state monitoring service and C++ statements for the computing core using an HTTP protocol. In addition, the display front end 360 runs in a JavaScript environment, and thus the present disclosure provides data exchange between the state monitoring service and the display front end 360 using the function of the RPC service. Of course, there are other conversion schemes between different language environments, and the present disclosure is not limited to any of these schemes. All the conversion schemes for different language environments fall within the scope of the present disclosure.

Fig. 5 shows a comparison of software data flows in a real vehicle test and in a simulation test. The dashed line part shows the software data flow in the real vehicle environment, and the solid line part shows the software data flow in the simulated environment in which a virtual sensor system is applied. In this software architecture, the virtual sensor system perfectly replaces real sensors on the vehicle, and the transmitted data will be received by the software on an intelligent system server with the same interface as the real hardware, thereby effectively simulating the data acquisition and transmission process for the autonomous vehicle in the real-world operating scene. The entire virtual server is independent of the normally operating intelligent system server from the hardware perspective, and will not affect any performance of the software part of the intelligent system server. The present disclosure creates a hardware environment and IO/CPU resource consumption consistent with the real vehicle, and simulates the real network load and computing resource usage of the sensor software part, so as to ensure the consistency with respect to computing resources. Moreover, the retrieval, reproduction, and transmission of data packets are performed independently in the virtual server, which effectively alleviates the phenomenon of unstable frame rate that may occur due to excessive memory usage when performed in the intelligent system server.

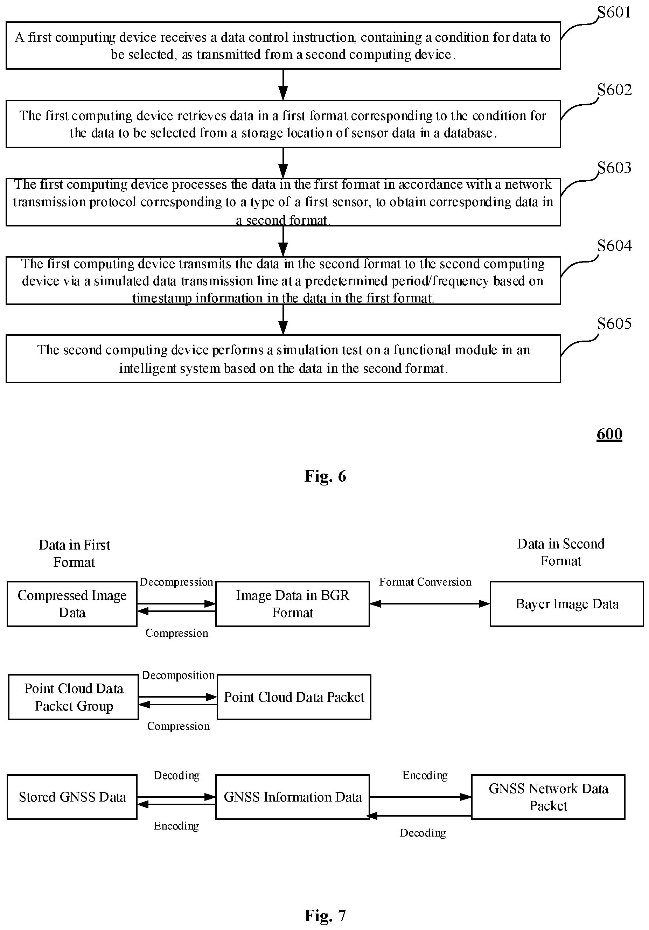

In this way, as shown in Fig. 6, an embodiment of the present disclosure provides a method 600 for simulation test. The method 600 includes the following steps.

At step S601, a first computing device receives a data control instruction, containing a condition for data to be selected, as transmitted from a second computing device.

The condition for the data to be selected may include at least one of a target data name, a target data identity (ID), and a target time period. Generally, a user can select a data condition on a display interface related to the second computing device. For example, the condition for the data to be selected can be determined by means of button selection, pull-down menu display, or manual input, so as to generate the corresponding data control instruction. Moreover, the display interface can also display a progress bar for playing back data, so as to provide a user with functions such as pause, start playing, drag, fast forward, rewind, and loop playback, thereby generating a corresponding pause control instruction, start control instruction, or fast forward control instruction, etc. It is to be noted that the first computing device 310 can have a corresponding state monitoring display interface, and the second computing device 320 can also have a corresponding data condition display interface. The two display interfaces can be implemented in the same physical device or in different physical devices, and the present disclosure is not limited thereto.

At step S602, the first computing device retrieves data in a first format corresponding to the condition for the data to be selected from a storage location of sensor data in a database.

For example, the condition for the data to be selected may be a target drive test data name being TC highway drive test data, and a target time period being 15:00 on August 3, 2020 to 16:00 on August 3, 2020. Accordingly, the first computing device can retrieve the data in the first format for the corresponding target time period in the TC highway drive test data from the storage location of the sensor data in the database. As another example, the condition for the data to be selected may be a target drive test data ID being 202008030001, and a target time period being 15:00 on August 3, 2020 to 16:00 on August 3, 2020. Accordingly, the first computing device can retrieve the data in the first format for the corresponding target time period in the data with the ID of 202008030001 from the storage location of the sensor data in the database. Here, the obtained data in the second format can be sensor data of a real scene as previously collected by various types of sensors, such as a point cloud capturing device, an image capturing device, and a GNSS sensor, e.g., compressed image data corresponding to the image capturing device, a point cloud data packet group corresponding to the lidar, and stored GNSS data corresponding to the GNSS sensor.

According to some embodiments of the present disclosure, the data can be retrieved from a database by calling a Python function, and multi-thread calling of Python can be supported. The database natively supports local data packets and Network Attached Storage (NAS) data packets. In a specific implementation, C++ calls Pybind11 to retrieve each frame of data for each sensor using Python scripts. It is to be noted that as Python multi-thread calling needs to be protected by Python gil (global lock), phenomena such as abnormal downtime may occur. However, the present disclosure does not use lock protection when using C++ multi-thread calling of Python. Therefore, the codes that call pybind are all locked and protected in this implementation.

The retrieved data will be cached. The present disclosure provides two buffer queues in the first computing device. The first buffer queue can be provided after the data is retrieved and before the data is forward processed, and the second buffer queue can be provided after the data is forward processed and before the data is transmitted. Each buffer queue is a priority queue, and the priorities are determined based on timestamps (such as timestamps of the collected data). The smaller the timestamp is, the higher the priority will be. Each buffer queue informs an interacting module whether to write or read data using a state value, which includes at least one of empty, full, and remaining buffer amount. In addition, in the process of performing the above step 602, according to an embodiment of the present disclosure, the following process may be performed.

In response to the first computing device receiving a pause control instruction from the second computing device while retrieving the data in the first format, it can pause the retrieving of the data in the first format, and enter a data-not-retrieved state. At this time, the process of simulation test of a functional module in an intelligent system will also be paused.

In response to the first computing device receiving a start control instruction from the second computing device while in the data-not-retrieved state, it can resume the retrieving of the data in the first format from the storage location of the sensor data in the database and enter a data-retrieved state. At this time, the process of simulation test of the functional module in the intelligent system will also be resumed.

In addition, in the process of retrieving a certain segment of data A in the first format from the storage location of the sensor data in the database, the first computing device may receive a data switching instruction from the second computing device (for example, an instruction to switch from the segment of data A to a segment of data B in the first format). Then, the first computing device can retrieve the segment of data B in the first format from the storage location of the sensor data in the database in accordance with the data switching instruction. After that, the second computing device can continue the simulation test of the functional module in the intelligent system based on the segment of data B in the first format. In particular, the data switching instructions may include one of switching of target data name, target data identity (ID), or target time period, etc., and the present disclosure is not limited to thereto.

At step S603, the first computing device processes the data in the first format in accordance with a network transmission protocol corresponding to a type of each first sensor, to obtain corresponding data in a second format.

The purpose of doing so is to obtain original data packets of various types of sensors for subsequent transmission over the network to simulate the network data transmission between the sensors and the intelligent system server, thereby reproducing the impact of the real network load condition on the processing performance the intelligent system server.

As described above, the types of sensors may include an image capturing device, a point cloud capturing device such as lidar, a GNSS sensor, etc. Each type of sensor has its corresponding data format and network transmission protocol. The specific data conversion schemes have been described in detail in connection with the method 200, and description thereof will be omitted here.

At step S604, the first computing device transmits the data in the second format to the second computing device via a simulated data transmission line at a predetermined period/frequency based on timestamp information of the data in the second format.

The first computing device transmits the data in the second format based on the timestamp information, e.g., triggering timestamp, exposure time, processing time, etc., which have been disclosed in detail in connection with the method 200, and description thereof will be omitted here. Here, data exposure time and processing time can be recorded, so as to effectively reproduce the data freezing phenomenon that occurs during the recording process, and improve the accuracy of playback of the sensor data. The use of the virtual server to play back the data can alleviate, to a certain extent, the data freezing that may occur during the playback process, thereby stabilizing the frame rate. That is, on one hand, the present disclosure aims to reproduce the data freezing in the recording process, and on the other hand, to alleviate the data freezing during playback.

According to some embodiments of the present disclosure, a user can select functional operations such as pause, play, and drag in a player progress bar of the second computing device, so as to control the playback process. It is assumed that the time at which the start time of the data packet recorded is t₀ and the system time at which the playback starts is T₀. If the playback goes in the normal playing order, the time difference Δt between the system time and the data time will be kept at T₀-t₀. Based on the time delay, the data frame corresponding to the current system time can be determined. However, if the user performs an operation such as pause, drag, etc., a current and new time difference needs to be determined based on the time t_{now} of the format data after the operation is performed and the current system time T_{now}, as Δt'=T_{now}-tnow.

For example, if the user clicks a pause button at t₂ in the progress bar, the system time is T₂ at this time, and the system time is T_{now} after a period of pause, and t_{now} is still t₂ at this time, so the new time difference will be Δt'=T_{now}-t₂. Similarly, if the user drags the progress bar from t₄ to ts, and the current system time after dragging is T_{now}, the new time difference will be Δt'=T_{now}-t₅.

In order to ensure time alignment and synchronization between the two computing devices, the current system time T_{now} can be the system time of the second computing device and can be transmitted from the second computing device to the first computing device.

Further, the first computing device can be connected to a second interaction module on the second computing device using the TCP, and the second interaction module can continuously forward playback time and monitored state items in the second computing device. A first interaction module in the first computing device can provide functions such as play, pause, drag time control, and loop playback by analyzing the data. The second interaction module transmits the control information once every second, and the first computing device updates the playback start time of the player based on the playback time in the control information, so as to ensure synchronization of the playback time on both sides.

In addition, in order to ensure the consistency of the transmitted data, during the transmission process, the second computing device can periodically transmit heartbeat information to the virtual server, and the first computing device can report its own data transmission state, such as the progress of transmission of the data in the second format, etc., in real time, so as to be synchronized with the system time of the second computing device, thereby ensuring that the data in the second format transmitted by the first computing device in real time is exactly the data expected by the second computing device.

At step S605, the second computing device performs a simulation test on a functional module in an intelligent system based on the received data in the second format.

In general, there may be many functional modules in the intelligent system. For example, in the field of autonomous driving, the functional modules may include various algorithm modules, such as a localization algorithm module ("Localization"), a perception algorithm module ("Perception"), a decision-making and planning algorithm module ("Planning"), or various state monitoring modules, such as camera operation state monitoring modules ("Camera1", "Camera2", etc.), lidar state detection modules ("Lidar1", "Lidar2", etc.), a GNSS signal monitoring module ("Novatel"), etc. According to the present disclosure, the sensor data outputted in each simulated scene is inputted to the algorithm module that needs to be tested, to obtain an execution result of the algorithm module. By testing the algorithm module in a simulated scene similar to the real-world scene, more effective test results can be obtained. For example, after obtaining the data in the second format for an image, the second computing device can perform a simulation test on an image-based perception algorithm module ("Perception") to determine whether the perception result is accurate. Of course, in fact, the second computing device can perform simulation tests on various functional modules synchronously. The overall simulation test scene is the same as the one in which data is collected directly by sensors. The details of the simulation test for each functional module will be omitted here.

In particular, when the second computing device performs the simulation test on the intelligent system based on the data in the second format, it first performs reverse processing (as opposed to the forward processing process at the first computing device, including a deserialization process) on the data in the second format to obtain the corresponding data in the first format, which is the data that can be directly used by the second computing device. Compared with the second computing device directly retrieving the data in the first format from the database for simulation, the present disclosure can faithfully reproduce the real data transmission and analysis process between the sensor and the vehicle server.

As shown in Fig. 7, the forward processing is shown on the left, and the reverse processing is shown on the right. The specific process of reverse processing will be described as follows.

For example, when the sensor includes an image capturing device, the corresponding data in the second format can be one or more original image data packets, which are typically Bayer image data. In this case, the Bayer image data can be converted to form image data in a BGR format. Then, the image data in the BGR format can be compressed to obtain compressed image data, as the data for simulation test.

As another example, when the sensor includes an point cloud capturing device such as lidar, the corresponding data in the second format can be one or more original point cloud data packets, generally including one or more point cloud data packets. In this case, the point cloud data packets can be combined to form a point cloud data packet group, as the data for the simulation test.

As yet another example, when the sensor includes a GNSS sensor (for example, an integrated navigation system device can be used), the corresponding data in the second format can be one or more original GNSS data packets, generally including one or more GNSS network data packets (e.g., denoted as GnssPacket). In this case, the GNSS network data packets can be decoded to form GNSS information data (e.g., denoted as Gnsslnfo). Then the GNSS information data can be encoded to form stored GNSS data (e.g., denoted as GnssMsg), as the data for simulation test.

It can be appreciated that when format conversion is performed on the data in the first format, other transmission protocols, such as USB transmission protocol, PCI-E transmission protocol, etc., can also be used, and the present disclosure is not limited thereto. In this case, the first computing device performs forward processing on the data in the first format in accordance with the transmission protocol to obtain the data in the second format. After receiving the data in the second format, the second computing device performs reverse processing with respect to the transmission protocol for the forward processing.

Further, in the step S605, the second computing device can perform the simulation test on the intelligent system based on the data in the second format as follows.

The second computing device can perform reverse processing on the received data in the second format of the first sensor to obtain the corresponding data in the first format, retrieve data in the first format for a second sensor from the database, and perform the simulation test on the intelligent system based on the data in the first format for the second sensor in combination with the data in the first format for the first sensor as obtained from the reverse processing. Here, the first sensor can be a sensor having a known transmission protocol, and the second sensor can be a sensor having an unknown transmission protocol. Here, the sensor data can be retrieved from the database, reproduced, and then transmitted, when the transmission protocols for various types of sensors are known (currently mainstream sensors, such as cameras, laser radars, and millimeter wave radars, etc., and vehicle by-wire controls have open source protocols, open SDK interfaces or are available via commercial cooperation). For some sensor having an unknown transmission protocol, the second computing device can directly retrieve the data in the first format from the database for playback, and during the playback, perform the simulation test of the functional module on the second computing device based on the played back data in the first format in combination with the data retrieved from the database and reproduced as transmitted from the first computing device. In this case, on one hand, the second computing device can obtain the reproduced data from the first computing device and perform reverse processing on the data, and on the other hand, the second computing device can directly retrieve the data from the database, and combine the two types of data for playback and simulation test.

For example, among an image capturing device, a lidar, and a GNSS sensor, it is assumed that the transmission protocol of the image capturing device is unknown (e.g., having a closed source transmission protocol, Type 2 sensor), and the transmission protocols of the lidar and the GNSS sensor are known (Type 1 sensor). The compressed image data of the image capturing device can be retrieved from the database for direct data playback at the second computing device, while the related data of the lidar and the GNSS sensor need to be reproduced and transmitted from the first computing device. In this way, the embodiments of the present disclosure can be compatible for some situations where the transmission protocols are unknown. On the premise of time synchronization, it can be combined with the data playback scheme to ensure the accuracy of the simulation test of the second computing device.

According to the technical solutions of the present disclosure, the first computing device can reversely solve the real original data formats for the sensor side and the vehicle by-wire control side based on the drive test data of the real sensor for different sensors and vehicle state information, and then transmit them orderly to the second computing device using their respective transmission protocols, so as to achieve the undifferentiated operation on the intelligent system side and a faithful reproduction of the drive test condition, including network load, computation load, etc., thereby ensuring high consistency.

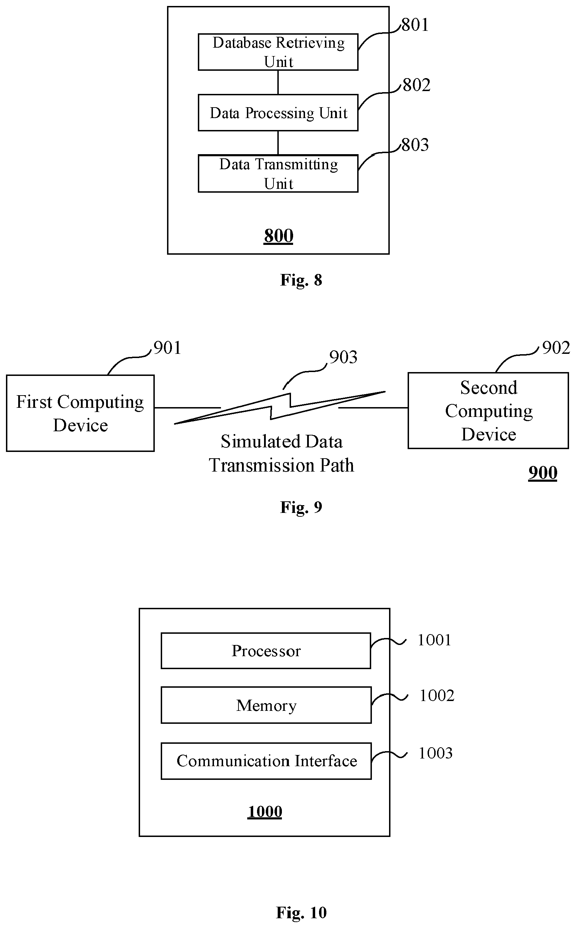

In addition, as shown in Fig. 8, an embodiment of the present disclosure provides a device 800 for simulation test, including:
a database retrieving unit 801 configured to retrieve data in a first format for a first sensor from a database;
a data processing unit 802 configured to process the data in the first format to obtain corresponding data in a second format, the second format being a format of data collected by the first sensor in a real-world operating environment; and
a data transmitting unit 803 configured to transmit the data in the second format to a second computing device, such that the second computing device performs a simulation test on an intelligent system based on the received data in the second format.

For details of the device 800 for simulation test according to the present disclosure, reference can be made to the description of Fig. 1 to Fig. 7, and description thereof will be omitted here.

In addition, as shown in Fig. 9, an embodiment of the present disclosure also provides a system 900 for simulation test, which includes: a first computing device 901 and a second computing device 902 connected with each other via a simulated data transmission line 903. Here, the simulated data transmission line 903 is substantially the same as the data transmission path between the first sensor and the second computing device in a real vehicle environment. For details of the simulation method, reference can be made to the description of the method 200, and description thereof will be omitted here.

The first computing device 901 is configured to retrieve data in a first format for a first sensor from a database, process the data in the first format to obtain corresponding data in a second format, and transmit the data in the second format to the second computing device 902.

The second computing device 902 is configured to perform a simulation test on an intelligent system based on the received data in the second format. In particular, the data in the second format is reverse processed first to obtain the corresponding data in the first format, and the simulation test is performed on the intelligent system based on the data in the first format. Further, data in the first format for a second sensor can be retrieved from the database, and the simulation test can be performed on the intelligent system based on the data in the first format for the second sensor in combination with the data in the first format for the first sensor as obtained from the reverse processing.

In addition, an embodiment of the present disclosure provides a computer readable storage medium. The computer readable storage medium contains a program or instructions which, when executed on a computer, cause the computer to perform the method for simulation test as described above.

In addition, an embodiment of the present disclosure provides a computing device 1000 as shown in Fig. 10, in which the technology described above in the present disclosure can be applied. The computing device 1000 may be a first computing device or a second computing device. The computing device 1000 may be implemented as including a memory 1002 and one or more processors 1003 communicatively connected to the memory 1002. The memory stores instructions, codes, and/or storage data executable by the one or more processors. The instructions, when executed by the one or more processors, cause the one or more processors to perform the method for simulation test as described above. The computing device 1000 may further include a communication interface 1003, which may implement one or more communication protocols (e.g., LTE, Wi-Fi, etc.).

The present disclosure creates a network topology consistent with that of a real vehicle for simulation of a network transmission layer. Since the simulated data transmission line is the same as the data transmission path between the real sensor and the vehicle server, it is possible to fully simulate the process during intelligent driving in which original data packets are collected by a sensor, transmitted to a vehicle server via a real transmission path, and processed by the vehicle server. The load condition of the transmission path is comprehensively considered, and the simulation test environment is closer to the real-world situation. Moreover, the present disclosure further simulates time delays of the sensor in different stages, such as exposure time and processing time, reproduces the time accuracy of the sensor data in the transmission process and processing process in the real-world scene, and improves the accuracy of the test result.

It can be appreciated by those skilled in the art that the embodiments of the present disclosure can be implemented as a method, a system or a computer program product. The present disclosure may include pure hardware embodiments, pure software embodiments and any combination thereof. Also, the present disclosure may include a computer program product implemented on one or more computer readable storage mediums (including, but not limited to, magnetic disk storage, CD-ROM, and optical storage) containing computer readable program codes.

The present disclosure has been described with reference to the flowcharts and/or block diagrams of the method, device (system) and computer program product according to the embodiments of the present disclosure. It can be appreciated that each process and/or block in the flowcharts and/or block diagrams, or any combination thereof, can be implemented by computer program instructions. Such computer program instructions can be provided to a general computer, a dedicated computer, an embedded processor or a processor of any other programmable data processing device to constitute a machine, such that the instructions executed by a processor of a computer or any other programmable data processing device can constitute means for implementing the functions specified by one or more processes in the flowcharts and/or one or more blocks in the block diagrams.

These computer program instructions can also be stored in a computer readable memory that can direct a computer or any other programmable data processing device to operate in a particular way. Thus, the instructions stored in the computer readable memory constitute a manufacture including instruction means for implementing the functions specified by one or more processes in the flowcharts and/or one or more blocks in the block diagrams.

These computer program instructions can also be loaded onto a computer or any other programmable data processing device, such that the computer or the programmable data processing device can perform a series of operations/steps to achieve a computer-implemented process. In this way, the instructions executed on the computer or the programmable data processing device can provide steps for implementing the functions specified by one or more processes in the flowcharts and/or one or more blocks in the block diagrams.

In the present disclosure, the principles and implementations of the present disclosure have been described with reference to specific embodiments. These embodiments are illustrative only, for facilitating understanding of the methods according to the present disclosure and core concepts thereof. Moreover, for those of ordinary skill in the art, modifications can be made to the specific implementations and application scenarios without departing from the principle of the present disclosure. In summary, the content of the specification should not be construed as limitation to the present disclosure.

## Claims

1. A method for simulation test, performed in a first computing device, the method comprising:
retrieving data in a first format for a first sensor from a database;
processing the data in the first format to obtain corresponding data in a second format, the second format being a format of data collection of the first sensor; and
transmitting the data in the second format to a second computing device, such that the second computing device performs a simulation test based on the data in the second format.

2. The method of claim 1, wherein said retrieving the data in the first format for the first sensor from the database comprises:
receiving a data control instruction, and
retrieving the data in the first format according to the data control instruction from a storage location of sensor data in the database.

3. The method of claim 2, wherein the data control instruction comprises at least one of a target data name, a target data identity, and a target time period.

4. The method of claim 2, wherein the data control instruction comprises a start control instruction and a pause control instruction, and said retrieving the data in the first format corresponding to the data control instruction from the storage location of the sensor data in the database comprises:
in response to receiving the pause control instruction, pausing the retrieving of the data in the first format, and entering a data-not-retrieved state; and
in response to receiving the start control instruction, resuming the retrieving of the data in the first format from the storage location of the sensor data in the database, and entering a data-retrieved state.

5. The method of claim 1, wherein said processing the data in the first format to obtain the corresponding data in the second format comprises:
processing the data in the first format in accordance with a network transmission protocol corresponding to a type of the first sensor, to obtain the corresponding data in the second format.

6. The method of claim 5, wherein the first sensor comprises an image capturing device, the data in the first format comprises compressed image data, and the network transmission protocol comprises a Gigabit Ethernet based image transmission standard protocol.
accordingly, said processing the data in the first format to obtain the corresponding data in the second format comprises:
decompressing the compressed image data to form image data in a Blue, Green, and Red (BGR) format; and
performing an image format conversion on the image data in the BGR format to form Bayer image data corresponding to the image capturing device, as one or more original image data packets conforming to the image transmission standard protocol.

7. The method of claim 5, wherein the first sensor comprises a lidar, the data in the first format comprises a point cloud data packet group, and the network transmission protocol comprises a User Datagram Protocol (UDP) and a Transmission Control protocol (TCP);
accordingly, said processing the data in the first format to obtain the corresponding data in the second format comprises:
decomposing the point cloud data packet group to form one or more point cloud data packets corresponding to the lidar as one or more original point cloud data packets conforming to the UDP and the TCP.

8. The method of claim 5, wherein the first sensor comprises a Global Navigation Satellite System (GNSS) sensor, the data in the first format comprises stored GNSS data, and the network transmission protocol comprises a Transmission Control Protocol (TCP);
accordingly, said processing the data in the first format to obtain the corresponding data in the second format comprises:
decoding the stored GNSS data to form GNSS information data; and
encoding the GNSS information data to form one or more GNSS network data packets corresponding to the GNSS sensor, as one or more original GNSS data packets conforming to the TCP.

9. The method of claim 1, wherein said transmitting the data in the second format to the second computing device comprises:
transmitting the data in the second format to the second computing device via a simulated data transmission line between the first sensor and the second computing device;
wherein the first sensor comprises a plurality of first sensors,
the simulated data transmission line is a network bus between any of the plurality of first sensors and the second computing device, or
the simulated data transmission line is a network bus having a median length among a plurality of network buses between the respective ones of the plurality of first sensors and the second computing device.

10. The method of claim 1, wherein the data in the second format contains timestamp information, and said transmitting the data in the second format to the second computing device comprises:
transmitting the data in the second format to the second computing device at a predetermined period based on the timestamp information of the data in the second format.

11. The method of claim 10, wherein said transmitting the data in the second format to the second computing device at the predetermined period/frequency based on the timestamp information of the data in the second format comprises:
transmitting the data in the second format to the second computing device at a predetermined period based on a corrected timestamp for the data in the second format, the corrected timestamp being a triggering timestamp for the data in the second format plus a time delay.

12. The method of claim 11, wherein the timestamp information comprises at least one of the triggering timestamp, exposure time, and processing time for the data in the second format, and the time delay comprises any of the following:
a sum of predetermined exposure time and predetermined processing time;
a sum of the exposure time for the data in the second format and the predetermined processing time; or
a sum of the exposure time and the processing time for the data in the second format.

13. The method of any of claims 1-12, further comprising: performing, by the second computing device, the simulated test based on the data in the second format by:
performing reverse processing on the received data in the second format for the first sensor, to obtain the corresponding data in the first format, and
performing the simulation test based on the data in the first format for the first sensor as obtained from the reverse processing, which comprises:
retrieving data in the first format for a second sensor from the database; and
performing the simulation test based on the data in the first format for the second sensor in combination with the data in the first format for the first sensor as obtained from the reverse processing.

14. A computer readable storage medium, comprising a program or instructions which, when executed on a computer, cause the computer to perform the method for simulation test according to any of claims 1 to 13.

15. A computing device, comprising a memory and one or more processors communicatively connected to the memory, wherein
the memory stores instructions executable by the one or more processors, the instructions, when executed by the one or more processors, causing the one or more processors to perform the method for simulation test according to any of claims 1 to 13.
